Europäisches Patentamt

European Patent Office

Office européen des brevets

(19)

(11) Numéro de publication : **0 335 793 B1**

(12)                     **FASCICULE DE BREVET EUROPEEN**

(45) Date de publication du fascicule du brevet :
20.05.92 Bulletin 92/21

(51) Int. Cl.[5] : **G01L 9/00, G01L 19/04**

(21) Numéro de dépôt : **89400864.8**

(22) Date de dépôt : **29.03.89**

(54) **Capteur de pression à semi-conducteur.**

(30) Priorité : **30.03.88 FR 8804175**
**30.03.88 FR 8804176**

(43) Date de publication de la demande :
**04.10.89 Bulletin 89/40**

(45) Mention de la délivrance du brevet :
**20.05.92 Bulletin 92/21**

(84) Etats contractants désignés :
**CH DE ES FR GB IT LI NL SE**

(56) Documents cités :
**DE-A- 2 714 032**
**DE-A- 3 211 968**
**DE-A- 3 212 026**
**GB-A- 1 049 130**
**ELECTRONICS LETTERS, vol. 18, no. 18, 2**
**septembre 1982, pages 794-796, Londres, GB;**
**S.L. SU et al.:**
**"Modulation-doped(Al,Ga)As/GaAs fets with**
**high transconductance and electron velocity"**

(56) Documents cités :
**ELECTRONICS LETTERS, vol. 18, no. 15, 22**
**juillet 1982, pages 644-645, Londres, GB; A.K.**
**SAXENA: "Ga1-xAlxAs material for highsensi-**
**tivity pressure sensors"**
**M. J. HOWES & D. V. MORGAN, "GALLIUM**
**ARSENIDE: MATERIALS, DEVICES, AND CIR-**
**CUITS", pp. 530 - 532.**

(73) Titulaire : **SCHLUMBERGER INDUSTRIES**
**50, avenue Jean Jaurès**
**F-92120 Montrouge (FR)**

(72) Inventeur : **Mosser, Vincent**
**20, Avenue de Verdun**
**F-92170 Vanves (FR)**
Inventeur : **Robert, Jean-Louis**
**12, Impasse du Romarin**
**F-34920 Le Cres (FR)**

(74) Mandataire : **Dupont, Henri**
**Schlumberger Industries Centre de**
**Recherche/SMR B.P. 620-05**
**F-92542 Montrouge Cédex (FR)**

# Description

La présente invention a pour objet un capteur de pression à semi-conducteur.

Selon un aspect, l'invention vise plus particulièrement, mais non exclusivement, un dispositif sensible à une pression hydrostatique à laquelle il est soumis, comprenant au moins une première couche d'arseniure de gallium-aluminium $Al_xGa_{1-x}As$ dont la teneur relative (x) en aluminium est inférieure à 0.25, et une seconde couche d'arseniure de gallium-aluminium $Al_yGa_{1-y}As$ dont la teneur relative (y) en aluminium est supérieure à (x) et comprise entre 0.15 et 1, et dans lequel se forme, à l'interface de ces deux couches, un canal de conduction dont la résistance électrique varie en fonction de la pression subie par ce dispositif.

La sensibilité à la pression de structures composées d'éléments semi-conducteurs des colonnes III et V du tableau de Mendeleiev est aujourd'hui connue.

En particulier, des structures d'arseniure de gallium

– aluminium sur un substrat d'arseniure de gallium ont déjà fait l'objet de plusieurs publications, et leur comportement en pression ou en température a notamment été décrit dans les articles suivants:

– "Pressure and compositional dependences of the Hall coefficient in $Al_yGa_{1-y}As$ and their significance", N.Lifshitz, A.Jayaraman, R.A.Logan, Physical Review B, Vol. 21, No 2, (5 Janvier 1980), pp.670 à 678;

– "The conduction band structure and deep levels in $Ga_{1-y}Al_yAs$ alloys from a high pressure experiment", A.Saxena, J. Phys. C: Solid State Phys. 13, (1980), pp.4323 à 4334;

– "Comprehensive analysis of Si-doped $Al_yGa_{1-y}As$ (x=0 to 1); Theory and experiments", N.Chand, T.Henderson, J.Klem, W.T.Masselink, R.Fisher, The American Physical Society, Physical Review B, Vol.30, No 8, (15 octobre 1984), pp. 4481 à 4492; et

– "Hydrostatic Pressure Control of the Carrier Density in GaAs/GaAlAs Heterostructures; role of the metastable deep levels", J.M.Mercy, C.Bousquet, J.L.Robert, A.Raymond et al., Surface Science 142, (1984), pp 298-305.

Une caractéristique des structures connues de cette famille est qu'une variation de pression déterminée conduit à une variation relative correspondante de la résistivité de leur couche sensible, qui est fixée une fois pour toutes par la nature du matériau utilisé. A température ambiante, la limite est de 45% par kilobar. Il en résulte que la résolution de telles structures, c'est-à-dire la plus petite valeur de variation de pression qu'elles sont susceptibles de détecter, est indissociablement liée à la plus petite variation relative décelable de la résistance de leur couche sensible.

On connait par ailleurs des capteurs de pression à jauges de contrainte, utilisant la piézorésistivité, dans lesquels la résistance électrique de chaque jauge varie en fonction de la contrainte qu'elle subit par application de la pression.

Il est possible, en choisissant judicieusement les paramètres de fabrication de ces capteurs, de réaliser des structures, en particulier des structures sensibles à la pression, capables de fonctionner dans des plages prédéterminées de conditions de mesure, par exemple dans une gamme préalablement choisie de température et de pression.

Cependant, ces structures sont le plus souvent fragiles, limitées dans leurs performances, et rendues complexes par le fait que les jauges, qui ne sont pas directement sensibles à la pression hydrostatique, doivent être associées à une conformation particulière du capteur, propre à convertir la pression hydrostatique à mesurer en une contrainte anisotrope à laquelle les jauges sont seulement sensibles.

Ces artifices conduisent à l'apparition de nombreux problèmes, notamment de stabilité à long terme et d'hystérésis.

De plus, l'adaptation d'un tel capteur à des conditions moyennes de fonctionnement étant réalisée une fois pour toutes au moment de sa fabrication, un capteur de ce type n'est pas susceptible de s'adapter à plusieurs gammes différentes de conditions moyennes de fonctionnement.

Dans ce contexte, un des buts de la présente invention est de proposer un capteur de pression capable de s'adapter dynamiquement à différentes conditions moyennes de mesure et de présenter, pour chacune d'elles, une résolution susceptible d'être ajustée et de prendre des valeurs élevées.

Les dispositifs décrits dans les documents DE-A-3211968 ou DE-A-2714032 utilisent des structures fonctionnant avec une distribution électronique tridimensionnelle contrairement à l'invention où la distribution électronique est bidimensionnelle.

Un des buts de la présente invention est de proposer un capteur de pression capable de s'adapter dynamiquement à différentes conditions moyennes de mesure et de présenter, pour chacune d'elles, une résolution susceptible d'être ajustée et de prendre des valeurs élevées.

Dans ce but, selon le premier aspect, l'invention propose un dispositif, sensible à la pression hydrostatique, comprenant au moins une première couche d'arseniure de gallium-aluminium $Al_xGa_{1-x}As$ dont la teneur relative (x) en aluminium est inférieure à 0.25, et une seconde couche d'arseniure de gallium-aluminium $Al_yGa_{1-y}As$ dont la teneur relative (y) en aluminium est supérieure à (x) et comprise entre 0.15 et 1, et dans lequel se forme, à l'interface de ces deux couches, un canal de conduction dont la résistance électrique varie en fonction d'une pression subie par ce dispositif, ces couches faisant partie d'un transistor à

2

effet de champ et à distribution électronique bidimensionnelle (TEGFET), comprenant un drain, une source et une grille.

Les transistors TEGFET sont connus par ailleurs et dans d'autres applications sans rapport avec la mesure de pression. On en trouve des descriptions dans des articles généraux tels que celui de M.J. Howes et D.V. Morgan "Gallium Arsenide: Materials, Devices, and Circuits", 1985, John Wiley and Sons Ltd, p 530-532 ou celui de la revue Electronics Letters, vol. 18, n° 18, 2 Sept. 1982, p 794-796.

La couche d'arseniure de gallium-aluminium $Al_yGa_{1-y}As$ est sélectivement dopée par des impuretés de la colonne IV A et/ou de la colonne VI A du tableau périodique, par exemple l'un au moins des élément Si, Ge, Sn, S, Se, et Te, à une concentration totale, intégrée sur l'épaisseur de cette couche, qui est avantageusement comprise entre $10^{12}$ et $10^{13}$ atomes par centimètre carré.

L'invention selon ce premier aspect propose en outre un procédé pour mesurer une pression hydrostatique comprenant une première opération consistant à soumettre un capteur de pression à la pression à mesurer, une seconde opération consistant à recueillir un signal de réponse du capteur, et une troisième opération consistant à déduire de ce signal la valeur de cette pression hydrostatique grâce à une loi connue reliant ce signal à cette valeur, ce procédé étant essentiellement caractérisé en ce que les première et seconde opérations sont effectuées en utilisant un capteur qui comprend au moins un transistor à effet de champ et à distribution électronique bidimensionnelle (TEGFET), comportant un drain, une source et une grille.

Un dispositif pour mettre en oeuvre la seconde opération mentionnée peut comprendre des moyens pour maintenir constants les potentiels de grille, de drain et de source, et des moyens pour mesurer le courant circulant entre le drain et la source.

Cependant, cette seconde opération peut aussi être mise en oeuvre grâce à des moyens pour maintenir constants les potentiels de drain et de source, et à des moyens pour ajuster le potentiel de grille de façon à maintenir constant le courant circulant entre le drain et la source.

Par ces caractéristiques, le dispositif et le procédé de ce premier aspect de l'invention sont susceptibles de s'adapter parfaitement au cas où les conditions de mesure de la pression hydrostatique évoluent, notamment par variation de cette pression elle-même ou par variation de la température, au voisinage de conditions de mesure moyennes, le procédé comprenant alors une opération consistant à ajuster, pour ces conditions de mesure moyennes, le potentiel de grille à une valeur à peine supérieure à la tension de seuil du transistor, et la tension drain-source à une valeur supérieure à la différence entre la tension de grille et la tension de seuil, de telle sorte que le transistor fonctionne en régime de saturation.

Comme cela est bien connu de l'homme de l'art, la tension de seuil du transistor est la tension de grille pour laquelle le courant drain-source s'annule. Par "une valeur à peine supérieure à la tension de seuil", on entend ici une valeur excédant d'au plus 1 volt la tension de seuil.

Le procédé de ce premier aspect de l'invention peut en outre être mis en oeuvre sous une autre forme, dans laquelle la première opération consiste essentiellement à soumettre à la pression hydrostatique à mesurer un ensemble de transistors à effet de champ et à distribution électronique bidimensionnelle intégrés dans un montage, connu sous le nom d'oscillateur en anneau, réalisé par la connexion d'un nombre impair de portes élémentaires, elles-mêmes composées de transistors et de diodes Schottky réalisés sur un même substrat. La troisième opération consiste alors essentiellement à recueillir le signal produit par cet oscillateur, et dont la fréquence est représentative de la pression à mesurer.

Selon un second aspect, la présente invention concerne plus particulièrement, mais non exclusivement, un transducteur de pression hydrostatique, comprenant au moins une couche semi-conductrice sensible à la pression qui est constituée d'un alliage d'au moins trois éléments des colonnes III et V du tableau périodique et dont la résistance électrique, variant avec ladite pression, a une valeur représentative de cette dernière à température constante, cette couche sensible à la pression étant solidaire d'un substrat constitué d'un alliage de deux desdits trois éléments et obtenue par épitaxie.

Les capteurs de pression à base de semi-conducteurs sont utilisés depuis une vingtaine d'années. Ils font habituellement appel à une structure comportant quatre jauges de silicium disposées en pont de Wheatstone, dopées intentionnellement par des impuretés acceptrices, de telle sorte qu'elles présentent une conductivité de type p, lesdites jauges étant réalisées par diffusion ou implantation des impuretés dans un substrat de silicium de conductivité de type n.

L'effet utilisé est la piézorésistivité, qui se manifeste par le fait que la résistance électrique de chaque jauge varie en fonction de la contrainte qu'elle subit par application de la pression.

Comme la résistivité du silicium n'est sensible qu'à des contraintes uniaxiales ou biaxiales, et non pas directement à la pression hydrostatique, les capteurs de ce type sont conçus de façon que l'application d'une pression hydrostatique se traduise par l'apparition de telles contraintes. Pour cela, ces capteurs comportent une membrane réalisée par gravure d'une de leurs faces, qui est mise à une pression de référence, tandis que l'autre face, qui supporte les jauges de contrainte, est mise à la pression hydrostatique à mesurer, de manière qu'apparaisse sur cette face un système de contraintes principalement dirigées selon le plan de la membrane.

Grâce à un choix judicieux de l'emplacement des jauges par rapport à ce système de contraintes, la résistance de deux des jauges du pont augmente avec la pression appliquée, tandis que la résistance des deux autres diminue. Le pont de Wheatstone est alors déséquilibré et un signal dépendant de la pression peut ainsi être obtenu.

Pour réaliser, avec un tel capteur, un transducteur de pression absolue, l'élément sensible en silicium doit être scellé sous pression nulle, par exemple par un verre de type Pyrex.

Bien que leurs propriétés soient assez satisfaisantes dans de nombreuses applications, ces capteurs présentent cependant quelques limitations qui en gênent l'utilisation dans des cas particuliers, éventuellement importants.

En particulier, non seulement le signal délivré par les capteurs de ce type est intrinsèquement représentatif à la fois de la pression et de la température, mais surtout une correction en température de ce signal représentatif de la pression et de la température s'est toujours avérée extrêmement délicate.

En effet, dans le meilleur des cas, une telle correction est réalisée grâce à une sonde de température disposée sur la même face que les jauges, mais en dehors de la membrane pour ne pas subir les contraintes liées à la pression; or, en raison de la structure hétérogène du capteur et du fait que la sonde de température ne se situe pas dans le même environnement que les jauges, la constante de temps de mise en équilibre thermique de la sonde en cas de variation de température, et/ou la variation des effets de relaxation mécanique consécutifs à une dilatation, dont la constante de temps est de l'ordre de une minute à une heure, ne sont jamais les mêmes pour la sonde et pour les jauges, de sorte que le signal représentatif de la pression ne peut pas être efficacement corrigé dans les cas où la pression et/ou la température varient rapidement.

De façon plus générale, ces capteurs connus font apparaître tous les problèmes inhérents à une structure composite, notamment des problèmes de stabilité à long terme et d'hystérésis.

On connaît par ailleurs des matériaux semi-conducteurs présentant une bonne sensibilité à la pression hydrostatique, propres à fournir un signal de réponse fonction de cette pression sans le recours à des structures complexes propres à la convertir en des contraintes uniaxiales ou biaxiales.

De nombreux matériaux de ce type ont été récemment étudiés, leur comportement en pression n'étant le plus souvent observé qu'en vue de la mise en évidence d'autres propriétés utilisables dans d'autres secteurs de la technique, comme la micro-électronique ou l'opto-électronique.

Parmi ces matériaux figurent notamment les semi-conducteurs indium - antimoine, galliumantimoine, aluminium - arsenic, indium - phosphore, arsenic - gallium, arsenic - indium, et leurs mélanges, dopés de type n par un élément des colonnes IV ou VI, en particulier par du silicium, de l'étain, du tellure, du soufre ou du sélénium.

En particulier, l'arséniure de gallium - aluminium a fait l'objet de plusieurs publications, notamment les trois publications mentionnees ci-dessus.

Si ces matériaux manifestent une sensibilité assez élevée à la pression hydrostatique, ils montrent aussi une sensibilité à la température qui, selon les alliages considérés et la valeur du dopage, peut être très importante.

C'est ainsi que le document déjà cité DE-A-3211968 décrit un capteur de pression à température constante et que le document DE-A-3212026 décrit un capteur de température à pression constante ayant une structure identique au précédent.

Ce problème d'une dépendance en température du signal de sortie supposé représenter la pression se pose même, avec des matériaux de ce type, de façon a priori tellement plus aigüe que dans le cas des capteurs à jauges piézorésistives de silicium que l'homme de l'art est naturellement conduit à écarter leur emploi pour la réalisation industrielle de capteurs de pression susceptibles d'être soumis à des variations rapides ou importantes de la température.

Dans ce contexte cependant, le second aspect de l'invention propose un moyen simple de compensation, en fonction de la température, du signal de sortie d'un capteur de pression hydrostatique comprenant un alliage d'au moins trois éléments des colonnes III et V du tableau périodique, permettant de tirer parti, même dans un milieu industriel, des avantages que présentent ces matériaux dans leur application aux capteurs de pression hydrostatique.

L'invention selon ce second aspect repose sur la mise en évidence du fait que les limitations qui s'appliquent aux sondes thermiques dans le cas des capteurs à jauges piézorésistives de silicium ne s'appliquent pas dans le cas des capteurs directement sensibles à la pression hydrostatique, du type précédemment mentionné, en raison de la structure homogène de ces derniers.

Un transducteur de pression hydrostatique conforme à ce second aspect de l'invention, qui comprend au moins une couche semi-conductrice sensible à la pression, constituée d'un alliage d'au moins trois éléments des colonnes III et V du tableau périodique et dont la résistance électrique, variant avec ladite pression, a une valeur représentative de cette dernière à température constante, cette couche sensible à la pression étant solidaire d'un substrat constitué d'un alliage d'au moins deux desdits trois éléments et obtenue par épitaxie, comprend en outre un capteur de température, supporté par le même substrat et susceptible de fournir un signal représentatif de la température de ce dernier.

Dans une forme de réalisation préférée du transducteur selon ce second aspect de l'invention, la couche sensible à la pression est constituée d'arseniure de gallium-aluminium $Al_xGa_{1-x}As$ dont la teneur relative (x) en aluminium est comprise entre 0.25 et 0.40, et le substrat est constitué d'arseniure de gallium.

Plus avantageusement encore, la teneur relative (x) en aluminium de la couche sensible à la pression est comprise entre 0.27 et 0.37, et a une valeur optimale comprise entre 0.29 et 0.35, et plus précisément encore entre 0.32 et 0.33.

De préférence, cette couche sensible à la pression est dopée par des impuretés de la colonne IV A et/ou de la colonne VI A du tableau périodique, plus particulièrement les éléments Si, Ge, Sn, S, Se, et Te, à une concentration totale comprise entre $2.10^{17}$ et $10^{20}$ atomes par centimètre cube.

Pour optimiser les corrections de température, il est avantageux que le capteur de température soit lui-même essentiellement constitué d'une couche semi-conductrice sensible à la température qui présente une distribution tridimensionnelle d'électrons, qui est constituée d'un alliage des mêmes éléments que ceux de la couche sensible à la pression, et dont la résistance électrique, variant avec la température du substrat, a une valeur représentative de cette dernière à pression constante, cette couche sensible à la température étant également obtenue par épitaxie.

Dans le cas où la couche sensible à la pression est constituée d'arseniure de gallium-aluminium, la couche sensible à la température est de préférence également constituée d'arseniure de gallium-aluminium $Al_yGa_{1-y}As$, avec une teneur relative (y) en aluminium comprise entre 0 et 0.25 ou entre 0.45 et 1.

Dans ce cas, lesdites couches sensibles à la pression et à la température peuvent être empilées l'une sur l'autre et séparées par une couche d'isolation.

Cette couche d'isolation est de préférence non dopée, formée par épitaxie, constituée d'arseniure de gallium-aluminium $Al_zGa_{1-z}As$ dont la teneur relative (z) en aluminium est comprise entre 0.40 et 0.50, et séparée du substrat au moins par la couche sensible à la pression.

Selon un mode de réalisation, le transducteur de ce second aspect de l'invention comprend une première zone dans laquelle les couches sensibles et d'isolation sont empilées les unes sur les autres, et une seconde zone, latéralement déplacée par rapport à la première, dans laquelle au moins la couche sensible supérieure a au moins été partiellement ôtée; il comprend en outre une première paire de contacts métalliques établis dans la première zone, séparés l'un de l'autre par une première distance, et une seconde paire de contacts métalliques établis dans la seconde zone, séparés l'un de l'autre par une seconde distance.

La première distance est avantageusement inférieure au double de la quantité représentée par la racine carrée de: $rho_0.e_0/((rho_1/e_1)+(rho_2/e_2))$, dans laquelle $rho_0$, $rho_1$ et $rho_2$ sont les résistivités respectives de la couche d'isolation, de la couche sensible la plus éloignée du substrat, et de la couche la plus proche du substrat, et dans laquelle $e_0$, $e_1$, et $e_2$ sont les épaisseurs respectives de la couche d'isolation, de la couche sensible la plus eloignée du substrat, et de la couche la plus proche du substrat. De préférence, la seconde distance est alors supérieure à cette même quantité.

D'autres caractéristiques et avantages de l'invention ressortiront clairement de la description qui en faite ci-après, à titre indicatif et nullement limitatif, en référence aux dessins annexés, parmi lesquels:

– la figure 1 est une vue en coupe d'un transistor TEGFET utilisable dans le cadre de la présente invention;

– la figure 2 est une vue en coupe d'un montage utilisant les principes de la présente invention;

– la figure 3 est un diagramme représentant la variation du courant drain-source d'un transistor TEGFET en fonction de la tension de grille appliquée à ce dernier;

– la figure 4 est un diagramme représentant les variations du courant drain-source du canal d'un transistor TEGFET en fonction d'une part de la tension de grille appliquée à ce dernier et d'autre part de la pression hydrostatique à laquelle il est soumis;

– la figure 5 est un agrandissement d'une partie de la figure 4;

– la figure 6 est un schéma d'un dispositif utilisant une première technique de mesure de la pression; et

– la figure 7 est un schéma d'un dispositif utilisant une seconde technique de mesure de la pression;

– la figure 8 est une vue en coupe d'un transducteur conforme à l'invention, faite suivant la ligne I-I de la figure 9;

– la figure 9 est une vue en plan d'un transducteur conforme à l'invention;

– la figure 10 est une vue en coupe d'un montage utilisant un transducteur conforme à l'invention.

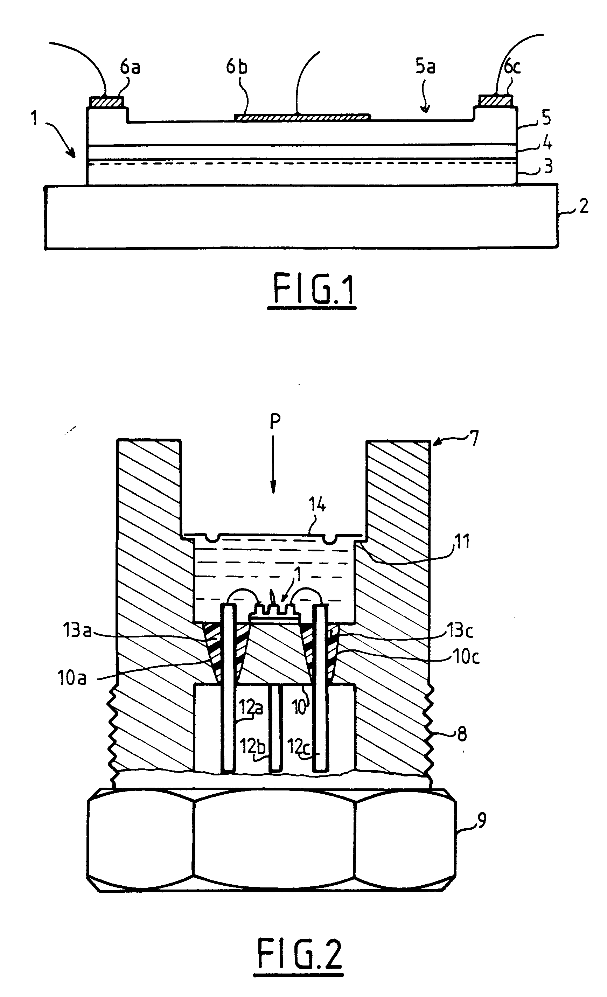

Les transistors TEGFET, tels que celui représenté sur la figure 1, sont connus dans le domaine de l'électronique rapide. Ils tirent leur désignation d'une abréviation de leur définition en langue anglaise, "Two-dimensional Electron Gas Field Effect Transistor", c'est-à-dire transistor à effet de champ et à distribution électronique bidimensionnelle.

Ils peuvent être produits, par exemple, par le procédé décrit dans l'article dans l'article "Growth of extremely uniform layers by rotating substrate holder with molecular beam epitaxy for applications to electro-optic and microwave devices", A.Y.Cho et K.Y-.Cheng, Appl. Phys. Lett. 38(5), 1 Mars 1981, pp. 360 à 362.

La structure du TEGFET 1 de la figure 1 est plus précisément la suivante.

Le substrat 2 est formé d'une plaquette d'arseniure de gallium GaAs semi-isolant, d'une épaisseur de l'ordre de 300 micromètres par exemple.

Sur ce substrat est déposée par épitaxie une couche 3 d'arseniure de gallium GaAs non dopé, d'une épaisseur de 1 à quelques micromètres, constituant une couche tampon destinée à offrir un bon état de surface aux couches ultérieures.

Sur cette couche tampon 3 peut être déposée par épitaxie une couche supplémentaire (non représentée), en arseniure de gallium-aluminium $Al_xGa_{1-x}As$ non dopé, dont la teneur relative (x) en aluminium est inférieure à 0.25 et dont l'épaisseur est par exemple de l'ordre de quelques dixièmes de micromètre. Globalement, la couche tampon 3, recouverte ou non de cette couche supplémentaire, constitue donc une couche d'arseniure de gallium-aluminium $Al_xGa_{1-x}As$ non dopé, dont la teneur relative (x) en aluminium, éventuellement nulle, est inférieure à 0.25.

Sur la couche tampon 3 ou sur cette couche supplémentaire optionnelle non représentée, est déposée, également par épitaxie, une couche de séparation 4 en arseniure de gallium-aluminium $Al_yGa_{1-y}As$ non dopé, dont la teneur relative (y) en aluminium est supérieure à (x) et comprise entre 0.15 et 1. L'épaisseur de cette couche de séparation 4 est par exemple de l'ordre de 0 à 30 nanomètres.

Sur la couche de séparation 4 est ensuite déposée, toujours par épitaxie, une couche 5 en arseniure de gallium-aluminium $Al_yGa_{1-y}As$ dopé, dont la teneur relative (y) en aluminium est sensiblement la même que celle de la couche de séparation 4, et dont l'épaisseur est par exemple comprise entre 30 et 100 nanomètres.

La couche 5 peut être dopée par des impuretés de la colonne IV A et/ou de la colonne VI A du tableau périodique, notamment par l'un au moins des éléments Si, Ge, Sn, S, Se, et Te, à une concentration totale, intégrée sur l'épaisseur de cette couche, comprise entre $10^{12}$ et $10^{13}$ atomes par centimètre carré.

Comme le montre symboliquement, par des tirets, la figure 1, un gaz d'électrons bidimensionnel apparaît à l'interface que forment les couches 4 et 5 d'arseniure de gallium-aluminium $Al_yGa_{1-y}As$ avec la couche 3, et sa couche supplémentaire éventuelle, en arseniure de gallium-aluminium $Al_xGa_{1-x}As$.

La couche 5 est, de façon connue, recouverte d'une couche de reprise de contact en arseniure de gallium GaAs, puis gravée pour présenter une dépression centrale 5a, après quoi des plots métalliques 6a, 6b, 6c, destinés à constituer respectivement le drain, la grille, et la source du transistor, sont déposés.

La figure 2 représente un mode de montage possible du transistor TEGFET 1 en tant que capteur de pression hydrostatique.

Le support du transistor 1 est constitué par une pièce d'acier 7 qui, à l'exception d'un filetage 8 et d'une tête à méplats 9 permettant son vissage, d'une surface transversale plane d'appui 10 et d'un décrochement périphérique interne est 11 de forme sensiblement cylindrique.

Le transducteur 1 est, du coté du décrochement, collé au moyen d'une colle souple sur la surface d'appui 10, dans laquelle sont pratiqués trois alésages 10a, 10b, 10c, dont deux sont visibles sur la figure 2.

Une borne électrique traversante, telle que 12a, 12b, 12c est maintenue dans chacun des alésages au moyen d'une perle de verre telle que 13a, 13b, 13c, qui assure d'une part la solidarisation de chaque borne avec la surface d'appui 10, d'autre part l'isolation électrique de cette borne et de cette surface, et enfin une obturation étanche des alésages 10a à 10c.

Du côté du décrochement 11, chaque borne électrique est connectée à un plot tel que 6a, 6b, ou 6c du transistor 1, l'ensemble étant noyé dans un volume d'huile isolante fermé par une membrane déformable en acier 14 soudée sur le décrochement 11.

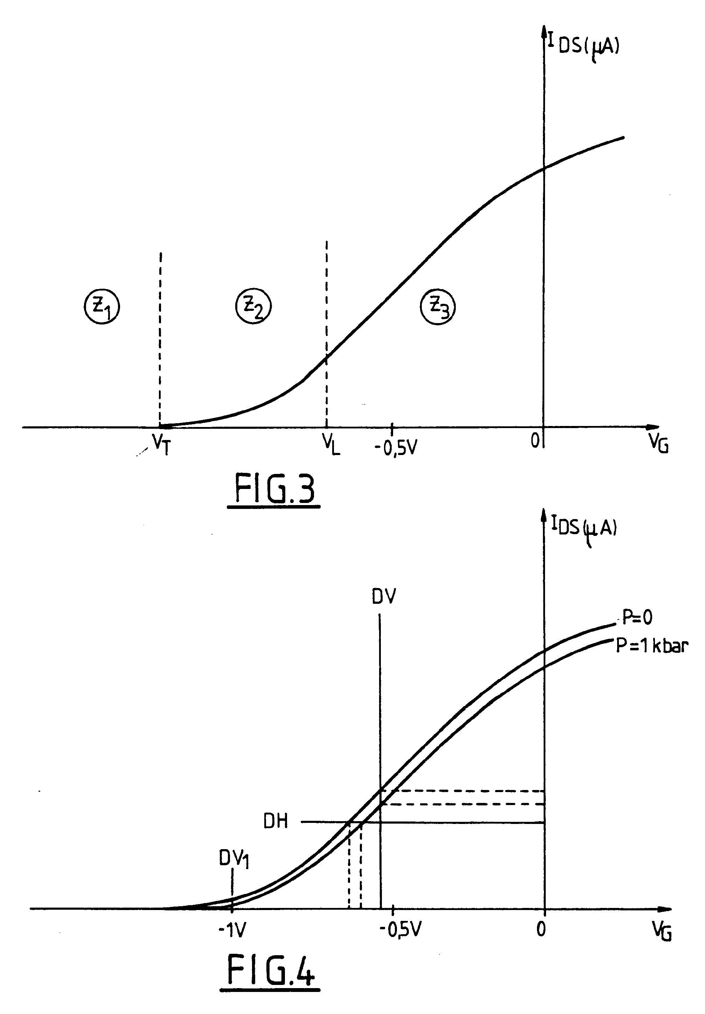

La pièce 7 ainsi conçue peut être vissée sur la paroi de toute enceinte dans laquelle règne une pression P à mesurer. Cette dernière, transmise à travers la membrane déformable 14 au volume d'huile baignant le transistor, soumet ce dernier à des conditions de pression hydrostatique et de température qu'il est possible, conformément à l'enseignement de l'invention, de mesurer de manière optimale de la façon décrite ci-après en référence aux figures 3 et 4.

La figure 3 représente la variation du courant $I_{DS}$ circulant entre le drain et la source d'un TEGFET en fonction de la tension $V_G$ appliquée sur sa grille, la tension $V_{DS}$ appliquée entre le drain et la source du transistor étant constante.

Cette figure fait apparaître une première zone Z1, dite zone de blocage, correspondant aux valeurs de la tension de grille $V_G$ pour lesquelles aucun courant $I_{DS}$ ne circule dans le transistor.

Une seconde zone Z2, dite zone de régime de saturation, apparaît pour des valeurs de la tension de grille supérieures à une valeur limite $V_T$, dite valeur de seuil, mais inférieures à la valeur de la tension de grille $V_L$ au delà de laquelle commence une troisième zone Z3, dite zone de régime linéaire, caractérisée par une loi affine de variation du courant $I_{DS}$ en fonction de la tension $V_G$.

La figure 4 représente également la variation du courant drain-source $I_{DS}$ en fonction de la tension $V_G$ appliquée sur la grille pour une valeur constante de la polarisation $V_{DS}$, mais pour deux valeurs distinctes d'une pression hydrostatique P appliquée sur le transistor.

Cette figure met immédiatement en évidence le fait que le courant $I_{DS}$ diminue lorsque la pression P appliquée augmente, phénomène dont l'exploitation optimale est à la base de l'invention.

La valeur du courant $I_{DS}$, mesurée en conservant la polarisation du transistor 1 soumis à la pression, c'est-à-dire en maintenant constants les potentiels de grille, de drain et de source de ce transistor, est en effet utilisable comme signal représentatif de la pression P.

Cette technique de mesure est illustrée par la droite verticale DV de la figure 4, qui, à deux valeurs différentes de la pression, fait correspondre de façon univoque deux valeurs différentes du courant $I_{DS}$.

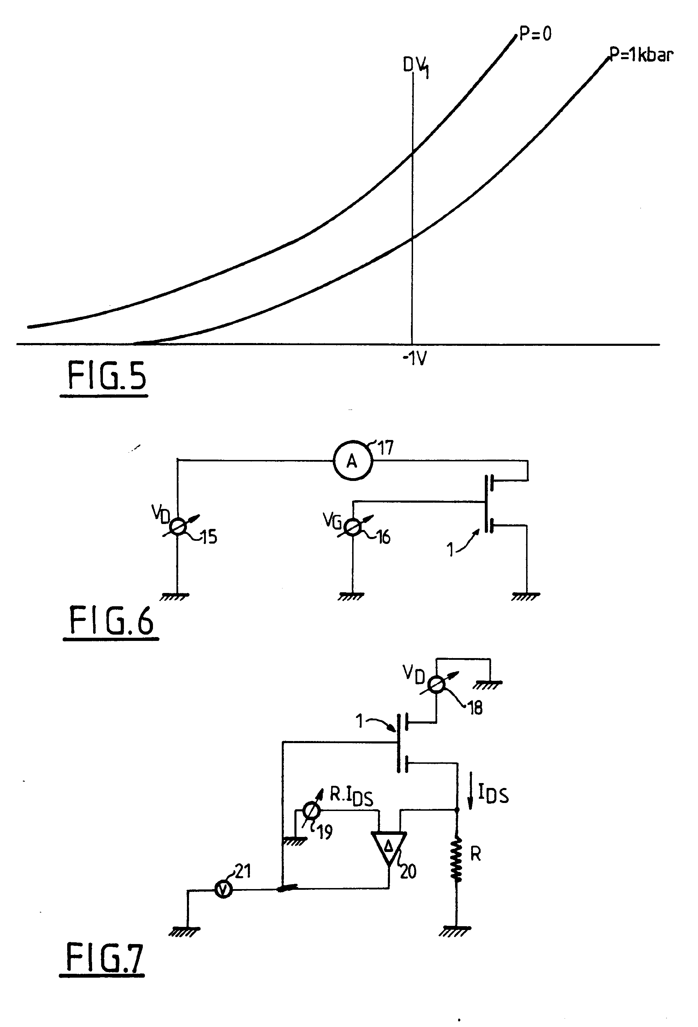

Un dispositif pour la mise en oeuvre de cette technique est représenté sur la figure 6. Outre le transistor 1, ce dispositif comprend une source de tension réglable 15 propre à fournir un potentiel de drain $V_D$ constant mais réglable, une source de tension réglable 16 propre à fournir un potentiel de grille $V_G$ constant mais réglable, et un ampèremètre 17 indiquant la valeur du courant $I_{DS}$. La source est également reliée à un potentiel constant, par exemple celui de la masse.

Cependant, comme le montre la figure 4, une autre technique de mesure est également possible puisqu'en effet la valeur à laquelle il faut ajuster le potentiel de grille $V_G$ de façon à maintenir constant le courant $I_{DS}$, en maintenant constants les potentiels de drain et de source, est aussi représentative de la pression hydrostatique à laquelle est soumis le transistor.

Cette seconde technique de mesure est illustrée par la droite horizontale DH de la figure 4 qui, à deux valeurs différentes de la pression, fait correspondre de façon univoque deux valeurs différentes de la tension de grille $V_G$ pour une même valeur du courant $I_{DS}$.

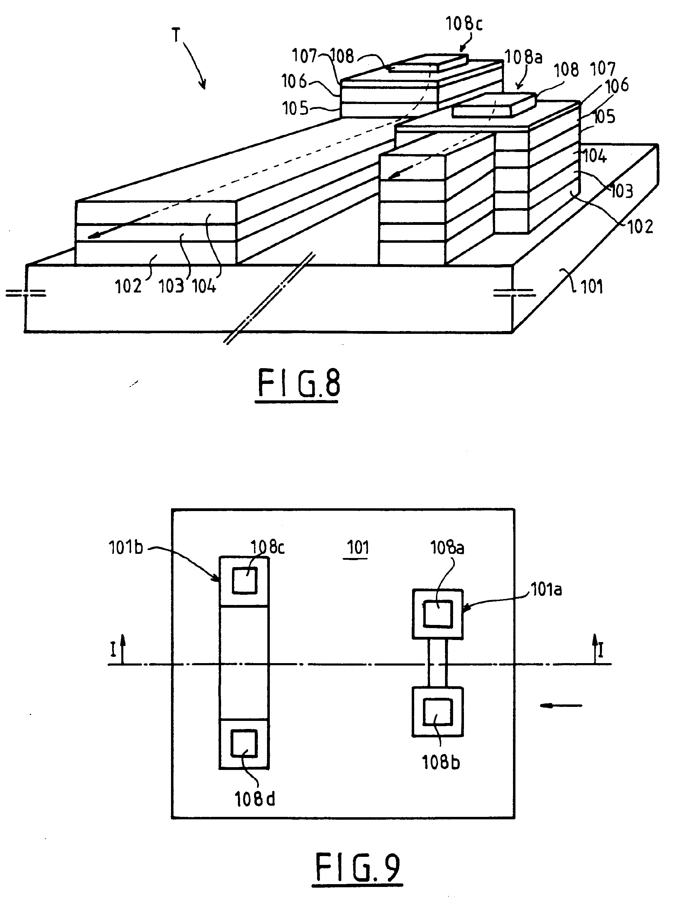

Un dispositif pour la mise en oeuvre de cette seconde technique est représenté sur la figure 7. Outre le transistor 1, ce dispositif comprend une source de tension réglable 18 propre à fournir un potentiel de drain $V_D$ constant mais réglable, une résistance de valeur R, connectée entre la source du transistor et la masse, et traversée par le courant $I_{DS}$, une source de tension réglable 19 propre à fournir un potentiel de référence égal au produit $R.I_{DS}$, un amplificateur différentiel 20 dont les entrées sont connectées à la source du transistor 1 et à la source de tension 19, et dont la sortie est connectée à la grille de ce transistor, et un voltmètre 21 indiquant la valeur du potentiel $V_G$.

Dans un tel montage, l'amplificateur 20 ajuste le potentiel de grille de façon que la tension aux bornes de la résistance R soit constante, ce qui fixe d'une part la valeur du potentiel de la source du transistor 1, et d'autre part la valeur du courant $I_{DS}$.

Un premier avantage, considérable, de l'utilisation d'un TEGFET comparée à l'utilisation d'un composant passif tel que l'hétérostructure dépourvue de grille décrite dans l'article "Hydrostatic Pressure Control of the Carrier Density in GaAs/GaAlAs Heterostructures; role of the metastable deep levels", précédemment cité, et qui est directement obtenu par la mise en oeuvre de l'une ou l'autre des deux techniques de mesure décrites en référence à la figure 4, réside dans le fait que le contrôle du potentiel de grille, qu'il est important de ne pas rendre flottant, assure une bonne immunité aux parasites en écrantant toute influence électrostatique du milieu extérieur sur le canal de conduction sensible à la pression.

Un second avantage résultant de l'utilisation d'un TEGFET comparée à l'utilisation d'un transistor différent, d'un MOSFET par exemple, réside dans le fait que le TEGFET est directement sensible à la pression hydrostatique, de sorte que les structures à la fois complexes, fragiles et limitées dans leurs performances notamment par les problèmes de stabilité à long terme et d'hystérésis qu'elles font apparaître, mais qui doivent néanmoins être utilisées pour convertir une pression hydrostatique à mesurer en une contrainte à laquelle le capteur est seulement sensible, deviennent inutiles.

Cependant, l'utilisation d'un TEGFET, comparée à l'utilisation d'un capteur passif, conduit encore à un autre avantage, s'il est employé conformément à l'invention, selon la procédure suivante.

Comme le montre la figure 4, la variation relative du courant $I_{DS}$ est maximale aux valeurs les plus négatives de la tension de grille, c'est-à-dire dans la zone Z2 de régime de saturation. Par exemple, la variation relative du courant $I_{DS}$ pour une variation absolue de 1 kbar de la pression, est de l'ordre de 14% lorsque le transistor fonctionne en régime linéaire (zone Z3), pour une valeur de $V_G$ voisine de -0.5 volts, alors qu'elle peut être supérieure à 50% lorsque le transistor fonctionne en régime de saturation, c'est-à-dire avec une tension de grille à peine supérieure à la valeur de seuil $V_T$.

Ainsi, puisque le réglage de la tension de grille permet un déplacement du point de mesure le long de chacune des courbes de la figure 4, il est possible d'adapter dynamiquement le capteur TEGFET au domaine de pression dans lequel il travaille et même, dans la mesure où chaque courbe peut éventuellement varier en fonction d'autres paramètres physiques, par exemple la température, il est possible d'adapter le capteur TEGFET à son environnement de mesure tout entier.

En particulier, dans le cas où les conditions de mesure de la pression hydrostatique évoluent, notamment par variation de cette pression elle-même ou par variation de la température, au voisinage de conditions de mesure moyennes, il est avantageux d'ajuster, pour ces conditions de mesure moyennes, le potentiel de grille à une valeur à peine supérieure à la tension de seuil du transistor, et la tension drain-source à une valeur supérieure à la différence entre la tension de grille et la tension de seuil, de telle sorte que le transistor fonctionne en régime de saturation.

Cette technique de mesure est illustrée par la verticale DV1 sur la figure 4, au voisinage de laquelle la résolution du capteur, pour des variations de pression autour d'une pression hydrostatique moyenne de 1 kbar, est excellente, comme le montre encore mieux l'agrandissement réalisé sur la figure 5.

Selon une autre technique de mesure, il est possible d'utiliser un TEGFET pour obtenir une mesure de pression hydrostatique sous la forme d'un signal de fréquence.

A cette fin, le capteur comprend un nombre impair d'inverseurs réalisés au moyen de transistors TEGFET et de diodes Shottky connectés de façon à constituer un oscillateur en anneau, délivrant un signal dont la fréquence est représentative des conditions de pression supportées par ces transistors.

Bien que la possibilité d'obtenir, au moyen de capteurs de pression actifs connectés en anneau pour constituer un circuit oscillant, un signal de fréquence représentatif d'une pression à mesurer ait déjà été décrite, par exemple dans le brevet européen EP 0.040.795, l'utilisation de TEGFET, conformément à l'enseignement de la présente invention, permet une mesure directe de la pression hydrostatique, sans la nécessité de recourir à l'emploi de membranes.

Le transducteur T de la figure 8 comprend un substrat 101, réalisé dans un alliage binaire d'éléments des colonnes III et V du tableau de Mendeleiev, et de préférence en arseniure de gallium GaAs, rendu semi-isolant par exemple par introduction de chrome. L'épaisseur de ce substrat est par exemple de l'ordre de 300 micromètres et sa résistivité est aussi élevée que possible.

Sur le substrat 101 est déposée par épitaxie une couche tampon 102, de même composition que le substrat, et d'une épaisseur d'au moins 1 micromètre environ, le rôle de cette couche étant d'offrir aux couches suivantes une surface d'appui de bonne planéité et de bonne qualité cristallographique.

Sur la couche tampon 102 est ensuite déposée par épitaxie une couche de séparation 103 non dopée et constituée d'un alliage d'au moins trois éléments des colonnes III et V du tableau de Mendeleiev, parmi lesquels figurent les deux éléments constituant le substrat, les éléments des colonnes III et V étant présents dans les mêmes proportions.

Par exemple, cette couche de séparation peut être constituée par un alliage $In_uGa_{1-u}As_vP_{1-v}$.

Dans le cas où le substrat est en arseniure de gallium, cette couche est de préférence constituée d'arseniure de gallium-aluminium $Al_uGa_{1-u}As$ et sa teneur relative (u) en aluminium est, à sa surface supérieure, au moins égale à 0.25.

Le rôle de cette couche de séparation, dont l'épaisseur est de l'ordre de quelques centièmes de micromètres, est d'éviter l'apparition d'une couche bidimensionnelle d'électrons à l'interface avec la couche suivante.

Sur la couche de séparation 103 est déposée par épitaxie une couche active 104 composée des mêmes éléments que la couche de séparation, quoiqu'en proportions éventuellemnt différentes, à savoir l'arseniure de gallium-aluminium $Al_xGa_{1-x}As$ pour un substrat en GaAs.

La couche active, qui est sensible à la pression, a une épaisseur de quelques dixièmes de micromètre à quelques micromètres, et est dopée par des impuretés de la colonne IV A et/ou de la colonne VI A, plus précisément par au moins un des éléments Si, Ge, Sn, S, Se, et Te, à une concentration totale comprise entre $2.10^{17}$ et $10^{20}$ atomes par centimètre cube, de manière à devenir le siège d'une distribution tridimensionnelle d'électrons. A titre d'exemple non limitatif, la couche active peut être dopée de silicium à une concentration de $10^{19}$ atomes par centimètre cube.

La teneur relative (x) en aluminium de la couche sensible 104 est comprise entre 0.25 et 0.40, plus avantageusement encore entre 0.27 et 0.37, et plus précisément entre 0.29 et 0.35, les valeurs comprises entre 0.32 et 0.33 étant optimales.

La teneur relative (u) en aluminium à la surface supérieure de la couche de séparation 103, dont il a déjà été précisé qu'elle était au moins égale à 0.25, doit en outre être au moins égale à la teneur relative (x) en aluminium de la couche sensible 104. Hormis cette contrainte, la couche de séparation 103 peut avoir une teneur en aluminium constante sur toute l'épaisseur de cette couche, ou présenter un gradient croissant de teneur en aluminium de sa surface la plus proche du substrat vers sa surface supérieure.

A ce stade du processus d'élaboration, chacune des couches 102 à 104 s'étend à priori sur toute la surface du substrat 101: ce n'est que par une opération ultérieure de gravure que ces couches peuvent être conformées en îlots tels que ceux qui apparaissent sur la gauche et sur la droite des figures 8 et 9; cependant, après dépôt des couches 102 à 104 sur le subtrat 101, plusieurs solutions sont possibles.

La première consiste à graver ces couches pour obtenir un îlot tel que celui qui est formé dans la zone de gauche du transducteur des figures 8 et 9, puis de déposer sur une seconde zone du transducteur, de préférence une zone dans laquelle le substrat a été mis à nu, une sonde de température propre à fournir un signal représentatif de la température du substrat, par exemple constituée par une couche mince métallique.

Une autre possibilité, correspondant au mode de réalisation représenté sur les figures 8 et 9 et à l'utilisation préférentielle d'un substrat en arseniure de gallium, consiste, avant toute gravure des couches 102 à 104, à déposer d'autres couches sur ces dernières, de la façon ci-après décrite.

Une couche d'isolation 105, non dopée, constituée d'arseniure de gallium-aluminium $Al_zGa_{1-z}As$ dont la teneur relative (z) en aluminium est par exemple comprise entre 0.40 et 0.50, est déposée par épitaxie sur la couche sensible à la pression 104.

Sur cette dernière couche d'isolation 105 est ensuite déposée, également par épitaxie, une couche 106 sensible à la température, constituée d'arseniure de gallium-aluminium $Al_yGa_{1-y}As$ dont la teneur relative (y) en aluminium est comprise entre 0 et 0.25 ou entre 0.45 et 1.

Dans cette structure, les couches sensibles à la pression 104, et à la température 106, sont donc empilées l'une sur l'autre et séparées par la couche d'isolation 105, cette dernière étant séparée du substrat par la couche sensible à la pression 104 et par les couches tampon 102 et de séparation 103.

De façon plus précise, la teneur en aluminium de la couche d'isolation est choisie de façon que les barrières électroniques entre cette couche et chacune des couches sensibles soient maximales.

Typiquement, les couches 104, 105, et 106 ont une épaisseur de l'ordre de 2 micromètres.

Contrairement à la couche d'isolation, qui n'est pas dopée, la couche sensible à la température 106 est, comme la couche sensible à la pression, dopée de type n par des impuretés de la colonne IV A et/ou de la colonne VI A, plus précisément par au moins un des éléments Si, Ge, Sn, S, Se, et Te, le silicium et l'étain en constituant les exemples les plus typiques.

Sur la couche 106 sensible à la température est déposée par épitaxie une couche 107 d'arseniure de gallium GaAs, dite "couche de reprise de contact", d'une épaisseur de 5 à 50 nanomètres, permettant l'établissement d'un bon contact électrique entre une couche de métallisation 108 qui la recouvre et l'une ou l'autre des couches sensibles à la pression 104 et à la température 106.

La couche de métallisation 108, par exemple constituée d'or - germanium - nickel alliés vers 450°C ou 500°C, constitue des plots séparés 108a, 108b, 108c, et 108d.

Après ces opérations de dépôt intervient un processus de gravure destiné à conduire, par exemple, à la structure des figures 8 et 9.

Les couches 107 à 102 déposées sur le substrat 101 sont taillées de manière à former deux îlots, apparaissant respectivement dans la première zone 101a, à droite des figures 8 et 9, et dans la seconde zone 101b, à gauche.

Puis, dans la seconde zone, les couches supérieures 107 à 105 sont ôtées, à l'exception des plots de métallisation, de sorte qu'en dehors de ces derniers, la couche sensible à la pression 4 constitue la couche externe.

La géométrie de l'ensemble est tel que la distance entre les plots de la première zone est très avantageusement inférieure au double de la quantité représentée par la racine carrée de: $rho_0.e_0/((rho_1/e_1)+(rho_2/e_2))$, dans laquelle $rho_0$, $rho_1$, et $rho_2$ sont les résistivités respectives de la couche d'isolation 105, de la couche 106 sensible à la température (qui est la plus éloignée du substrat), et de la couche 104 sensible à la pression (qui est la plus proche du substrat), et dans laquelle $e_0$, $e_1$, et $e_2$ sont les épaisseurs respectives de la couche d'isolation, de la couche sensible la plus éloignée du substrat, et de la couche la plus proche du substrat.

La distance entre les plots de la seconde zone est, quant à elle, de préférence supérieure à cette même quantité.

Dans une telle structure, les courants électriques dominants qui sont susceptibles d'être appliqués par des sources de courant extérieures entre les plots 108a, 108b d'une part, et 108c, 108d d'autre part, suivent les chemins indiqués schématiquement par des flèches sur la figure 8.

Si ces sources délivrent des courants constants et connus, la tension entre les plots 108a et 108b est essentiellement représentative de la température du transducteur T que constitue la structure décrite, donc en particulier du substrat 101, tandis que la tension entre les plots 108c et 108d est essentiellement représentative de la pression à laquelle est soumis ce transducteur.

Le signal représentatif de la température peut être utilisé, de façon en soi connue, mais avec une efficacité propre à la présente invention, pour corriger le signal représentatif de la pression, sans qu'apparaissent des problèmes d'hétérogénéité d'environnement des couches sensibles présentes dans le transducteur.

De préférence, comme le montre la figure 9, le canal de conduction de la première zone est plus étroit que le canal de conduction de la seconde zone, de façon que ces deux canaux présentent des résistances électriques du même ordre de grandeur.

Après la gravure, réalisée conformément aux indications qui précèdent, il est très préférable, comme cela est bien connu de façon générale dans le domaine des semi-conducteurs, de procéder à une passivation du transducteur. Cette dernière est effectuée par le dépôt d'une couche de passivation qui recouvre toute la structure, puis par une ouverture sélective de cette couche de passivation, permettant de ne remettre à nu que les plots 108a à 108d, ces derniers recevant ultérieurement une nouvelle couche de métallisation qui dépasse le niveau de la couche de passivation.

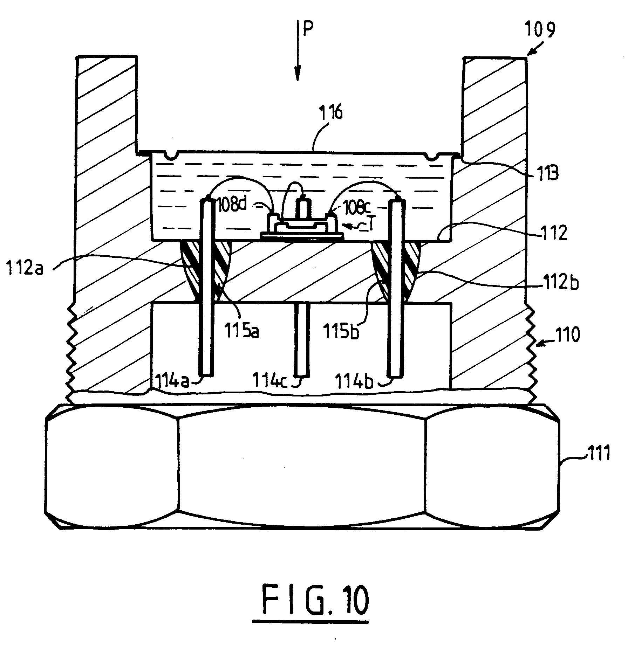

La figure 10 représente un mode de montage possible d'un transducteur conforme à la présente invention.

Le support du transducteur est constitué par une pièce d'acier 109 qui, à l'exception d'un filetage 110 et d'une tête à méplats 111 permettant son vissage, d'une surface transversale plane d'appui 112 et d'un décrochement périphérique interne 113, est de forme sensiblement cylindrique.

Le transducteur T est, du côté du décrochement, collé au moyen d'une colle souple sur la surface d'appui 112, dans laquelle sont pratiqués quatre alésages 112a, 112b, 112c, 112d, dont deux sont visibles sur la figure 10.

Une borne électrique traversante, telle que 114a, 114b, 114c est maintenue dans chacun des alésages au moyen d'une perle de verre telle que 115a, 115b, qui assure d'une part la solidarisation de chaque borne avec la surface d'appui 112, d'autre part l'isolation électrique de cette borne et de cette surface, et enfin une obturation étanche des alésages 112a à 112d.

Du côté du décrochement 113, chaque borne électrique est connectée à un plot tel que 108c ou 108d du transducteur T, l'ensemble étant noyé dans un volume d'huile isolante fermé par une membrane déformable en acier 116 soudée sur le décrochement 113.

La pièce 109 ainsi conçue peut être vissée sur la paroi de toute enceinte dans laquelle règne une pression P à mesurer. Cette dernière, transmise à travers la membrane déformable 116 au volume d'huile baignant le transducteur, soumet ce dernier à une pression hydrostatique et à une température qui sont mesurés grâce aux variations de résistance détectées, aux bornes 114a à 114d à l'extérieur de l'enceinte.

## Revendications

1. Dispositif sensible à la pression hydrostatique, comprenant au moins une première couche (3) d'arseniure de gallium-aluminium $Al_xGa_{1-x}As$ dont la teneur relative x en aluminium est inférieure à 0.25, et une seconde couche (5) d'arseniure de gallium-aluminium $Al_yGa_{1-y}As$ dont la teneur relative y en aluminium est supérieure à x et comprise entre 0.15 et 1, et dans lequel se forme, à l'interface de ces deux couches, un canal de conduction dont la résistance électrique varie en fonction d'une pression subie par ce dispositif, ces couches (3, 5) faisant partie d'un transistor (1) à effet de champ et à distribution électronique bidimensionnelle (TEGFET), comprenant un drain (6a), une source (6c) et une grille (6b).

2. Dispositif suivant la revendication 1, caractérisé en ce que ladite couche d'arseniure de gallium-aluminium $Al_yGa_{1-y}As$ est sélectivement dopée par des impuretés de la colonne IV A et/ou de la colonne VI A du tableau périodique à une concentration totale, intégrée sur l'épaisseur de cette couche, comprise entre $10^{12}$ et $10^{13}$ atomes par centimètre carré.

3. Dispositif suivant la revendication 1 ou 2, caractérisé en ce qu'il comprend des moyens (15,16) pour maintenir la grille, la drain et la source à des potentiels constants, et des moyens (17) pour mesurer le courant circulant entre le drain et la source.

4. Dispositif suivant la revendication 1 ou 2, caractérisé en ce qu'il comprend des moyens (18,19) pour maintenir le drain et la source à des potentiels constants, et des moyens (20) pour ajuster le potentiel de grille de façon à maintenir constant le courant ($I_{DS}$) circulant entre le drain et la source.

5. Procédé pour mesurer une pression hydrostatique comprenant une première opération consistant à soumettre un capteur de pression à la pression à mesurer, une seconde opération consistant à recueillir un signal de réponse du capteur, et une troisième opération consistant à déduire de ce signal la valeur de cette pression hydrostatique grâce à une loi connue reliant ce signal à cette valeur, caractérisé en ce que le capteur comprend au moins un transistor à effet de champ et à distribution électronique bidimensionnelle (TEGFET), comportant un drain, une source et une grille.

6. Procédé suivant la revendication 5, applicable au cas où les conditions de mesure de ladite pression hydrostatique évoluent, notamment par variation de cette pression elle-même ou par variation de la température, au voisinage de conditions de mesure moyennes, caractérisé en ce que, pour ces conditions de mesure moyennes, le potentiel de grille est ajusté à une valeur à peine supérieure à la tension de seuil du transistor, et la tension drain-source à une valeur supérieure à la différence entre la tension de grille et la tension de seuil, de telle sorte que le transistor fonctionne en régime de saturation.

7. Procédé suivant la revendication 5, caractérisé en ce que la première opération consiste essentiellement à soumettre à la pression hydrostatique à mesurer un ensemble de transistors à effet de champ et à distribution électronique bidimensionnelle intégrés à un oscillateur en anneau, et en ce que ladite troisième opération consiste essentiellement à recueillir un signal de fréquence représentatif de la pression à mesurer.

## Patentansprüche

1. Gegen hydrostatischen Druck empfindliche Vorrichtung, die mindestens eine erste Schicht (3) aus Galliumaluminiumarsenid $Al_xGa_{1-x}As$ aufweist, deren relativer Gehalt x an Aluminium geringer als 0,25 ist, und die eine zweite Schicht (5) aus Galliumaluminiumarsenid $Al_yGa_{1-y}As$ aufweist, deren relativer Gehalt y an Aluminium höher als x ist und zwischen 0,15 und 1 liegt, und in welcher sich, an der Grenzschicht zwischen beiden Schichten, ein Leitungskanal bildet, dessen elektrischer Widerstand sich in Abhängigkeit des auf die Vorrichtung ausgeübten Drucks ändert, wobei die Schichten (3, 5) Teil eines Feldeffekttransistors (1) mit zweidimensionaler Elektronenverteilung (TEGFET) sind, der eine Drain-Elektrode (6a), eine Source-Elektrode (6c) und eine Gate-Elektrode (6b) aufweist.

2. Vorrichtung nach Anspruch 1, dadurch gekennzeichnet, daß die Schicht aus Galliumaluminiumarsenid Al$_y$Ga$_{1-y}$As selektiv mit Verunreinigungen aus der Gruppe IV A und/oder der Gruppe VI A des Periodensystems dotiert ist, wobei die Gesamtkonzentration der Verunreinigungen, über die Dicke dieser Schicht aufsummiert, zwischen 10$^{12}$ und 10$^{13}$ Atomen/cm$^2$ liegt.

3. Vorrichtung nach Anspruch 1 oder 2, dadurch gekennzeichnet, daß sie Mittel (15, 16) aufweist, um die Gate-Elektrode, die Drain-Elektrode und die Source-Elektrode bei konstanten Potentialen zu halten, und Mittel (17) zur Messung des zwischen der Drain-Elektrode und der Source-Elektrode fließenden Stroms.

4. Verfahren nach Anspruch 1 oder 2, dadurch gekennzeichnet, daß sie Mittel (18, 19) aufweist, um die Drain-Elektrode und die Source-Elektrode bei konstanten Potentialen zu halten, und Mittel (20) um das Potential der Gate-Elektrode in der Weise anzupassen, daß der zwischen der Drain-Elektrode und der Source-Elektrode fließende Strom (I$_{DS}$) konstant gehalten wird.

5. Verfahren zur Messung eines hydrostatischen Druckes, bei dem in einem ersten Schritt ein Druckfühler dem zu messenden Druck ausgesetzt wird, in einem zweiten Schritt ein Antwortsignal des Fühlers aufgenommen wird und in einem dritten Schritt von diesem Signal der Wert des hydrostatischen Drukkes dank eines bekannten Gesetzes abgeleitet wird, welches dieses Signal diesem Wert zuordnet, dadurch gekennzeichnet, daß der Druckfühler mindestens einen Feldeffekttransistor mit zweidimensionaler Elektronenverteilung (TEGFET) umfaßt, der eine Drain-Elektrode, eine Source-Elektrode und eine Gate-Elektrode aufweist.

6. Verfahren nach Anspruch 5, anwendbar falls sich die Meßbedingungen, bei denen der hydrostatische Druck gemessen wird, in der Nähe der mittleren Meßbedingungen verändern, insbesondere bei Variation des Druckes selbst oder bei Temperaturänderungen, dadurch gekennzeichnet, daß unter den mittleren Meßbedingungen das Potential der Gate-Elektrode auf einen Wert eingestellt wird, der gerade oberhalb der Schwellenspannung des Transistors liegt, und die Spannung Drain-Source auf einen Wert eingestellt wird, der über der Differenz der Spannung der Gate-Elektrode und der Schwellenspannung liegt, so daß der Transistor im Bereich der Sättigung arbeitet.

7. Verfahren nach Anspruch 5, dadurch gekennzeichnet, daß der erste Schritt im wesentlichen darin besteht, eine Gruppe von Feldeffekttransistoren mit zweidimensionaler Elektronenverteilung dem zu messenden hydrostatischen Druck auszusetzen, die durch einen Ringoszillator aufsummiert werden, und daß der dritte Schritt im wesentlichen darin besteht, ein Frequenzsignal aufzunehmen, das dem zu messenden Drucß entspricht.

## Claims

1. A device, sensitive to hydrostatic pressure, comprising at least a first layer (3) of aluminium gallium arsenide Al$_x$Ga$_{1-x}$As in which the relative proportion $x$ of aluminium is less than 0.25, and a second layer (5) of aluminivm gallium arsenide Al$_y$Ga$_{1-y}$As in which the relative proportion $y$ of aluminium is greater than $x$ and lies in the range 0.15 to 1, and in which a conduction channel is formed at the interface of these two layers, the resistance of the channel varying as a function of a pressure to which the device is subjected, said layers (3, 5) forming parts of a two-dimensional electron gas field effect transistor (TEGFET) (1) comprising a drain (6a), a source (6c), and a gate (6b).

2. A device according to claim 1, characterized in that said layer of aluminium gallium arsenide Al$_y$Ga$_{1-y}$As is selectively doped with impurities from column IV and/or column VI of the periodic table, at a total concentration, integrated over the thickness of the layer, which lies in the range 10$^{12}$ to 10$^{13}$ atoms per square centimeter.

3. A device according to claim 1 or claim 2, characterized in that it comprises means for maintaining the gate, drain and source at constant voltages, and means for measuring the current flowing between the drain and the source.

4. A device according to claim 1 or 2, characterized in that it comprises means (15, 16) for maintaining the drain and source at constant voltages, and means (17) for adjusting the gate voltage so as to maintain the current (I$_{DS}$) flowing between the drain and the source constant.

5. A method of measuring hydrostatic pressure comprising a first operation consisting of subjecting a pressure sensor to the pressure to be measured, a second operation consisting of obtaining a response signal from the sensor, and a third operation consisting of deducing the value of the hydrostatic pressure from said signal by means of a known law linking said signal to said value, characterized in that the sensor comprises at least one two-dimensional electron gas field effect transistor (TEGFET), comprising a drain, a source and a gate.

6. A method according to claim 5, applicable in the case where the hydrostatic pressure measurement conditions vary about mean measurement conditions, in particular by variation of the pressure itself or by variation of the temperature, characterized in that, for these mean measurement conditions, the gate voltage is adjusted to a value just above the threshold voltage of the transistor, and the drain-source voltage to a value greater than the difference between the gate voltage and the threshold voltage, such that the transistor operates under saturation conditions.

7. A method according to claim 5, characterized in that the first operation consists essentially in applying the hydrostatic pressure to be measured to a group of two-dimensional electron gas field effect transistors integrated in a ring oscillator, and in that said third operation consists essentially of obtaining the signal whose frequency is representative of the pressure to be measured.

## FIG.1

## FIG.2

$$\underline{FIG.3}$$

$$\underline{FIG.4}$$

FIG.5

FIG.6

FIG.7

FIG.8

FIG.9

16

P

109

116

113

108d

108c

T

112

112a

112b

115a

115b

110

114a

114c

114b

111

# F I G. 10